# FASCICULE DE BREVET EUROPEEN

(11) **EP 0 370 912 B1**
(45) Date de publication et mention de la délivrance du brevet: **08.09.1993**
(21) Numéro de dépôt: 89403238.2
(22) Date de dépôt: 23.11.1989
(51) Int. Cl.: B23K 26/12, C23C 16/48, H01L 21/268

(54) **Machine à microfaisceau laser d'intervention sur des objets à couche mince, en particulier pour la gravure ou le dépôt de matière par voie chimique en présence d'un gaz réactif**
Lasermikrostrahlmaschine zur Intervention auf Gegenstände mit dünnen Schichten, besonders zum Ätzen oder zur chemischen Absetzung von Stoff in Anwesenheit eines reaktiven Gases
Laser micro-beam intervention machine for thin layer objects, in particular for etching or chemically depositing matter in the presence of a reactive gas

(30) Priorité: 25.11.1988 FR 8815435
(43) Date de publication de la demande: 30.05.1990
(73) Titulaire: FRANCE TELECOM, 75015 Paris (FR); BERTIN & CIE, F-78373 Plaisir Cédex (FR)
(72) Inventeur: Auvert, Geoffroy, F-38000 Grenoble (FR); Georgel, Jean-Claude, F-13140 Lambesc (FR); Guern, Yves, F-83470 Pourrieres (FR)
(74) Mandataire: Ramey, Daniel

(56) Documents cités:
- FR-A- 2 608 484
- US-A- 3 626 046
- US-A- 4 340 617
- PATENT ABSTRACTS OF JAPAN vol. 8, no. 246 (C-251)(1683) 10 novembre 1984,& JP-A-59 126774 (NIPPON DENKI K.K.) 21 juillet 1984,

## Description

L'invention concerne une machine à microfaisceau laser d'intervention sur des objets à couche mince, tels que des circuits électroniques, des écrans plats, des têtes de lecture magnétiques, notamment pour la gravure et le dépôt de matière sur les surfaces de ces objets, par voie chimique en présence d'un gaz réactif.

On connaît déjà, par le brevet français 2 608 484 du demandeur, une machine à microfaisceau laser permettant de réaliser notamment des opérations de découpe très fines et très précises sur des couches minces de matériau, pour la correction de micro-défauts sur des circuits électroniques, leur réparation, leur reconfiguration, leur micro-analyse, etc... Cette machine comprend essentiellement une source laser, telle qu'un laser continu à argon, un système optique de transmission du faisceau laser émis par la source jusqu'à un objectif de microscope orienté vers l'objet à traiter, et des moyens de support et de déplacement dans cet objet le long de trois axes perpendiculaires. Cette machine a en outre l'avantage de permettre une observation continue, sur un écran vidéo, du travail du microfaisceau laser sur l'objet à traiter.

Une telle machine pourrait également être utilisée pour réaliser, par voie chimique, une gravure et un dépôt de matière sur une couche mince de matériau par application du principe décrit dans le brevet US 4 340 617. Selon ce principe, on amène un faisceau laser sur une couche mince de matériau, placée dans un gaz réactif approprié, de préférence à basse pression. Le dégagement de chaleur au point d'impact du faisceau laser et le flux de photons provoquent respectivement, une réaction chimique entre le matériau de la couche mince et le gaz réactif, et une réaction chimique dans ce gaz, qui se traduisent par une gravure et un dépôt de matière localisés au point d'impact du faisceau laser.

Comme l'objet à couche mince doit être dans un gaz réactif à basse pression, on peut pour cela le placer dans un réacteur ou boîte étanche de faible volume, dont une face est formée par un hublot transparent au rayonnement laser, puis fermer la boîte, y faire le vide et y introduire le gaz réactif à la pression voulue. En pratique, le hublot de passage du faisceau laser doit avoir une surface relativement importante, permettant d'intervenir sur la totalité ou la quasi-totalité de la surface d'un circuit électronique, et une épaisseur suffisante pour résister à des variations de pression de l'ordre d'une atmosphère (10⁵ Pa).

Cette épaisseur de matériau transparent, relativement importante, a deux inconvénients majeurs :
- elle fixe une distance minimale entre la surface de l'objet à traiter et l'extrémité de l'objectif de microscope utilisé pour la focalisation du faisceau laser,
- elle dégrade fortement les qualités optiques d'un faisceau laser de très faible diamètre.

On ne peut donc utiliser, pour travailler sur un tel réacteur, qu'un objectif de microscope ayant un pouvoir grossissant relativement faible, et l'on ne peut réduire le diamètre du faisceau laser à des valeurs de l'ordre du micron, permettant un travail très fin et très précis.

On connaît par le document JP-A-59-126 774 une machine de dépôt de métal en phase vapeur, qui comprend une enceinte étanche contenant un réacteur étanche recevant un objet à couche mince, des moyens permettant d'abaisser la pression dans l'enceinte et dans le réacteur, des moyens permettant d'introduire un gaz réactif à basse pression dans le réacteur, et un hublot monté dans un orifice d'une paroi de l'enceinte pour permettre le passage d'un faisceau laser depuis un objectif de focalisation situé à l'extérieur de l'enceinte jusqu'à l'objet à couche mince placé dans le réacteur étanche. En raison de la différence importante de pression qui existe entre l'intérieur et l'extérieur de l'enceinte étanche, le hublot de passage du faisceau laser doit avoir une épaisseur importante, et la machine décrite dans ce document antérieur est soumise aux mêmes inconvénients que ceux indiqués ci-dessus.

Pour pallier ces inconvénients, on a proposé une machine dans laquelle l'objet à couche mince n'est pas enfermé dans une boîte étanche, mais simplement posé sur un support sous l'objectif de microscope et entouré de zones annulaires concentriques dont la première est reliée à une amenée de gaz réactif et dont les suivantes sont reliées à une ou à des sources de dépression. De cette façon, le faisceau laser passant par l'objectif de microscope arrive directement, sans passer à travers un hublot, sur la couche mince de l'objet, qui est dans une ambiance localisée de gaz réactif, isolée dynamiquement de l'atmosphère extérieure par les zones annulaires concentriques de dépression.

Toutefois, cette technique connue ne permet pas de bien maîtriser la pression et la composition du gaz réactif sur la zone de travail, et ne permet pas non plus d'opérer à basse pression, ce qui est essentiel pour une bonne qualité de gravure ou de dépôt de matière sur la couche mince de l'objet.

En outre, comme le gaz réactif est en général toxique ou explosif, il en résulte un problème de sécurité du personnel travaillant sur la machine.

L'invention a notamment pour but d'apporter une solution simple et efficace à ces divers problèmes.

Elle a pour objet une machine qui permette la gravure et le dépôt de matière par voie chimique sur un objet à couche mince, au moyen d'un microfaisceau laser très fin, ayant un diamètre par exemple inférieur au micron.

Elle a également pour objet une machine de ce type, qui permette de contrôler très précisément la pression et la composition de l'atmosphère réactive, et de travailler à basse pression.

Elle a encore pour objet une machine de ce type, qui soit utilisable dans un environnement industriel.

Elle propose, à cet effet, une machine à microfaisceau laser d'intervention sur des objets à couche mince, en particulier pour la gravure ou le dépôt de matière par voie chimique en présence d'un gaz réactif, comprenant une enceinte étanche dans laquelle est logé un réacteur étanche recevant un objet à couche mince, des moyens pour abaisser la pression dans l'enceinte et dans le réacteur, des moyens pour introduire un gaz réactif à basse pression dans le réacteur, et une source laser associée par des moyens optiques de transmission du faisceau laser à un objectif de focalisation orienté vers l'objet à couche mince, caractériséeen ce que l'objectif de focalisation est un objectif de microscope disposé à l'intérieur de l'enceinte et porté par une paroi de celle-ci, et en ce que le réacteur est fermé de façon étanche par un couvercle transparent de faible épaisseur traversé par le faisceau laser issu de l'objectif de microscope.
La pression dans l'enceinte et dans le réacteur peuvent être sensiblement égales et varier de façon simultanée, de sorte que le couvercle transparent du réacteur n'a pas à résister à des variations importantes de pression et peut donc avoir une épaisseur très faible. Il en résulte la possibilité d'utiliser un microfaisceau laser de très faible diamètre, inférieur à 1 µm.

Avantageusement, lorsque l'objet à couche mince est constitué d'une plaque transparente dont une seule face comporte une couche mince, comme c'est le cas par exemple des écrans plats à cristaux liquides et des masques de photolithographie, il peut servir lui-même de couvercle transparent du réacteur. Il est alors monté à la place du couvercle du réacteur, de manière à fermer ce dernier de façon étanche, et sa face portant la couche mince est tournée vers l'intérieur du réacteur, pour pouvoir être au contact de l'atmosphère réactive. Le faisceau laser traverse la plaque transparente de l'objet et vient agir sur la couche mince, pour une gravure, un dépôt, ou une découpe.

Selon une autre caractéristique de l'invention, la machine comprend des moyens de régulation de la pression dans l'enceinte, à une valeur sensiblement égale ou légèrement supérieure à celle de la pression du gaz réactif dans le réacteur, par introduction d'un gaz inerte tel que l'azote dans l'enceinte.

Ces moyens permettent d'éviter l'établissement d'une trop grande différence de pression entre le réacteur et l'enceinte lorsqu'on introduit un gaz réactif dans le réacteur, et de maintenir une légère surpression à l'extérieur du réacteur pour éviter les fuites de gaz réactif, celui-ci pouvant être plus ou moins toxique, explosif ou corrosif vis à vis de certains matériaux.

Selon une autre caractéristique de l'invention, la paroi de l'enceinte, à laquelle est fixé l'objectif de microscope, comporte un hublot transparent au rayonnement laser pour la transmission de ce rayonnement à l'objectif de microscope, ayant une épaisseur lui permettant de résister à des variations de pression d'au moins une atmosphère.

Ce hublot placé en amont de l'objectif de microscope, est traversé par un faisceau laser ayant un diamètre relativement important, sensiblement égal à celui de l'entrée de l'objectif de microscope. Ce hublot peut donc avoir une épaisseur relativement importante, sans inconvénients.

Selon encore une autre caractéristique de l'invention, le réacteur est porté par des moyens moteurs de déplacement par rapport à trois axes perpendiculaires, et ces moyens moteurs sont également logés dans ladite enceinte.

Le fond de celle-ci comprend des passages traversants, dans lesquels sont montés à étanchéité des conduits reliés aux moyens d'abaissement et de régulation de pression et à une source de gaz réactif, et des câbles ou fils d'alimentation et de commande des moyens de déplacement du réacteur.

Pour permettre l'accés au réacteur et la maintenance de la machine, l'enceinte comprend une paroi amovible, par exemple sa paroi horizontale supérieure, à laquelle est fixé l'objectif de microscope ou une tourelle porte-objectifs. Des vérins pneumatiques sont associés à cette paroi mobile pour aider à son soulèvement, et à sa mise en position de service.

Par ailleurs, la machine comprend, outre une voie de transmission du faisceau laser, une voie d'éclairage et une voie de visualisation aboutissant toutes à l'objectif de microscope, la voie de visualisation comportant des filtres optiques, une caméra vidéo et un écran vidéo permettant l'observation en continu de l'action du microfaisceau laser sur l'objet à couche mince.

Dans la description qui suit, faite à titre d'exemple, on se réfère aux dessins annexés dans lesquels :
- la figure 1 est une vue schématique, en coupe verticale, illustrant les caractéristiques essentielles d'une machine selon l'invention ;
- la figure 2 est une vue schématique en perspective, avec arrachement partiel, d'un mode de réalisation préféré d'une partie d'une machine selon l'invention ;
- la figure 3 représente cette partie de la machine en perspective, dans une position différente.

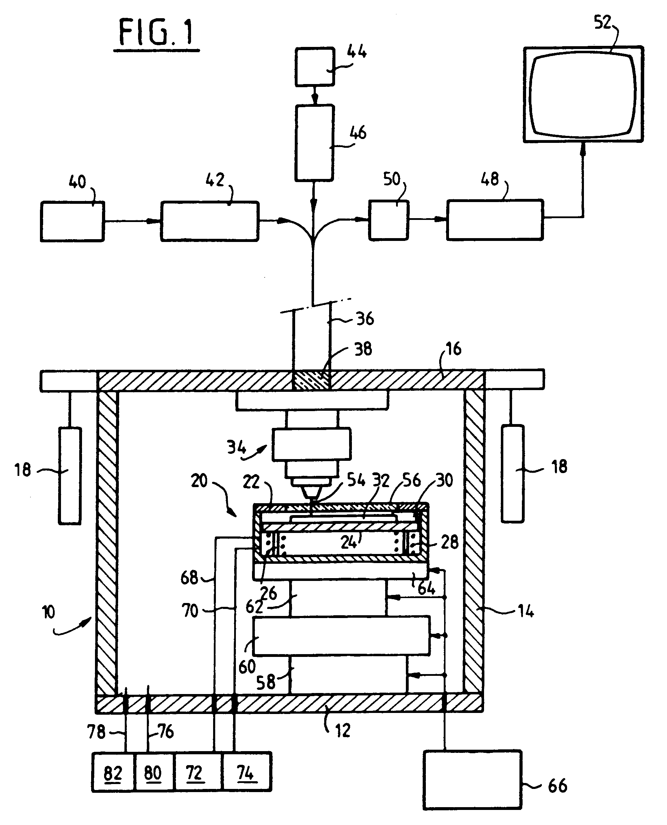

On se réfère d'abord à la figure 1 qui représente schématiquement les moyens constitutifs essentiels de la machine selon l'invention.

Cette machine comprend une enceinte étanche 10, capable de résister à des variations de pression d'au moins une atmosphère, et réalisée par exemple en aluminium.

Cette enceinte comprend un fond 12, une paroi verticale 14 qui est par exemple cylindrique à section circulaire, et un couvercle mobile 16 monté par exemple pivotant autour d'un axe horizontal transversal et déplaçable autour de cet axe au moyen de vérins pneumatiques 18.

A l'intérieur de l'enceinte 10 se trouve un réacteur 20 constitué d'une boîte étanche de volume relativement faible, comprenant un couvercle mobile 22 formant hublot, monté à étanchéité, par exemple par vissage, sur le bord supérieur du réacteur 20. A l'intérieur de celui-ci se trouve une table horizontale 24 guidée en déplacement vertical sur des colonnes 26 et sollicitée vers le couvercle 22 par des ressorts 28. Une cale d'épaisseur 30 est interposée entre la table 24 et le couvercle 22 et permet de régler la distance entre eux, et de positionner un objet 32 à couche mince, monté sur la table 24.

Un objectif de microscope 34 ou, de préférence une tourelle porte-objectifs, est fixé au couvercle 16 et s'étend verticalement dans l'enceinte 10, en étant orienté perpendiculairement au plan de l'objet 32 à couche mince. L'objectif de microscope 34 reçoit un faisceau laser 36 par l'intermédiaire d'un hublot 38 monté à étanchéité dans un orifice traversant du couvercle 16.
Le faisceau laser 36 est émis par une source laser 40 telle par exemple qu'un laser continu à argon, et transmis par un système optique 42 qui est généralement du même type que celui décrit dans le brevet français 2 608 484 précité.

Une source lumineuse 44 associée à un système optique de transmission 46, et une caméra vidéo 48, par exemple du type à cellules C.C.D, associée à un système de filtres optiques 50 et à un écran vidéo 52, constituent respectivement une voie d'éclairage et une voie de visualisation qui sont réunies avec la voie de transmission du faisceau laser avant l'entrée dans l'objectif du microscope, c'est-à-dire légèrement en amont du hublot 38.

Le faisceau laser traversant le hublot 38 a un diamètre sensiblement égal à celui de l'objectif d'entrée du microscope, par exemple de 5 à 6 mm. Le hublot 38 est réalisé en une matière transparente au rayonnement laser et a une épaisseur suffisante, par exemple de l'ordre du cm, pour résister à des variations de pression de l'ordre d'une atmosphère. Compte tenu du diamètre du faisceau laser 36 et de la puissance rayonnée, la traversée du hublot 38 n'altère pas les qualités optiques du rayonnement transmis.

Le microfaisceau laser 54 sortant de l'objectif de microscope traverse le hublot 22 du réacteur 20. Ce hublot est formé d'une plaque mince 56 de matière transparente au rayonnement laser, ayant une surface sensiblement égale à la surface utile de l'objet 32 à couche mince, tel par exemple qu'un circuit électronique, et a une épaisseur faible de l'ordre du millimètre pour permettre une bonne transmission du microfaisceau laser 54 dont le diamètre est compris par exemple entre 0,1 et 10 µm. La faible épaisseur de la plaque transparente 56, comprise par exemple entre 0,5 et 2 mm, permet de respecter la distance objet à couche mince-objectif de microscope, qui peut être comprise entre 3 et 20 mm, en fonction de la frontale de l'objectif 34.

Le réacteur 20 est porté par des moyens 58, 60, 62, 64 permettant de le déplacer le long de trois axes perpendiculaires, et de le faire tourner autour d'un axe vertical de façon à pouvoir orienter l'objet 32 angulairement par rapport à un axe horizontal de déplacement du réacteur 20. Ces moyens 58, 60, 62, 64 sont reliés à un circuit de commande 66 extérieur à l'enceinte 10 et assurant également l'alimentation électrique des moteurs de ces moyens de déplacement.

Le réacteur 20 est quant à lui relié par des conduits souples 68, 70 à des moyens 72 d'abaissement de pression et à des moyens 74 d'alimentation en atmosphère gazeuse réactive, tandis que l'enceinte 10 est reliée, par des conduits 76 et 78 à des moyens 80 d'abaissement de pression et des moyens 82 de régulation de pression par introduction d'un gaz neutre ou chimiquement inerte dans l'enceinte 10, par exemple de l'azote.

Les différents câbles et conduits de liaison précités sont montés à étanchéité dans des trous traversants du fond 12 de l'enceinte.

Cette machine fonctionne de la façon suivante;
un objet 32 à couche mince est positionné sur la table 24 du réacteur 20, puis le couvercle 22 est fixé, par exemple au moyen de vis traversant une couronne métallique annulaire solidaire de la plaque transparente 56. La cale 30 permet de maintenir l'objet 32 en place sur la table 24, et de régler la distance entre cette table et la plaque transparente 56, de sorte que, en fonction de la frontale de l'objectif utilisé, la distance plaque transparente 56-objet 32 soit la plus grande possible, pour éviter ou réduire l'échauffement de la plaque 56 et le risque de dépôt de matière sur cette plaque.

L'enceinte 10 est refermée, par mise en place du couvercle 16 au moyen des vérins pneumatiques 18. Ces derniers permettent également de maintenir le couvercle 16 en place avec une certaine force de pression, pour assurer l'étanchéité de l'enceinte 10.

Le vide est ensuite progressivement fait dans l'enceinte 10 et dans le réacteur 20, de façon simultanée, par les moyens 72 et 80. Lorsqu'une pression suffisamment faible a été atteinte, par exemple de l'ordre de 0,1 mb (10Pa), le gaz réactif voulu est introduit dans le réacteur 20, à la pression voulue, qui est comprise entre 1 et 100 mb et qui par exemple est de l'ordre de 10 mb.

Ce gaz réactif peut être du silane lorsqu'on veut procéder à un dépôt de silicium sur une zone particulière de l'objet 32, ou bien du chlore si l'on veut procéder à une gravure sur une couche mince d'aluminium ou de silicium de l'objet 32.

Simultanément, la pression est régulée dans l'enceinte 10, par introduction d'un gaz inerte tel que l'azote, pour être légèrement supérieure à la pression dans le réacteur 20. Ainsi, on évite tout risque de fuite de gaz réactif hors du réacteur 20.

Pour cela, un capteur de dépression est prévu, de préférence dans l'enceinte 10, pour mesurer la différence de pression entre le réacteur et l'enceinte, et commander en conséquence, par un circuit approprié, des vannes analogiques montées sur les conduits de vide et de gaz neutre de l'enceinte. On parvient ainsi à faire varier rapidement la pression dans le réacteur et dans l'enceinte, sans risquer un éclatement du couvercle transparent du réacteur.

Les moyens 58 et 60 permettent de déplacer le réacteur le long de deux axes horizontaux perpendiculaires, les moyens 62 permettent de le déplacer en hauteur le long d'un axe vertical, et les moyens 64 permettent de définir son orientation angulaire par rapport à l'un des axes horizontaux de déplacement. Le circuit 66 de commande peut être actionné par un opérateur, ou bien être lui-même sous commande d'un système de traitement de l'information.

Le faisceau laser émis par la source 40 et transmis par le système 42, traverse le hublot épais 38 du couvercle 16 et est focalisé par l'objectif 34 de façon à former un microfaisceau laser 54 de diamètre faible, compris entre 0,1 et 10 µm par exemple, au point d'impact sur la surface à traiter.

La voie d'éclairage 44, 46 et la voie de visualisation 50, 48, 52, permettent d'observer en continu, sur l'écran 52, l'action du microfaisceau laser sur la surface à traiter.

L'opération de gravure et/ou de dépôt peut être commandée par un opérateur, ou par un système de traitement de l'information.

En variante, le couvercle transparent 22 du réacteur est formé par l'objet 32 à couche mince, quand celui-ci est constitué d'une plaque plane transparente au rayonnement laser et dont une seule face comporte une couche mince absorbant le rayonnement laser (cas par exemple des écrans plats à cristaux liquides et des masques de photolithographie). L'objet 32 est alors monté de façon étanche sur le réacteur 20, avec sa face à couche mince orientée vers l'intérieur du réacteur, de sorte que la couche mince puisse être au contact du gaz réactif.

Le faisceau laser agit alors sur la couche mince, à travers la plaque transparente de l'objet, pour une gravure, un dépôt ou une découpe.

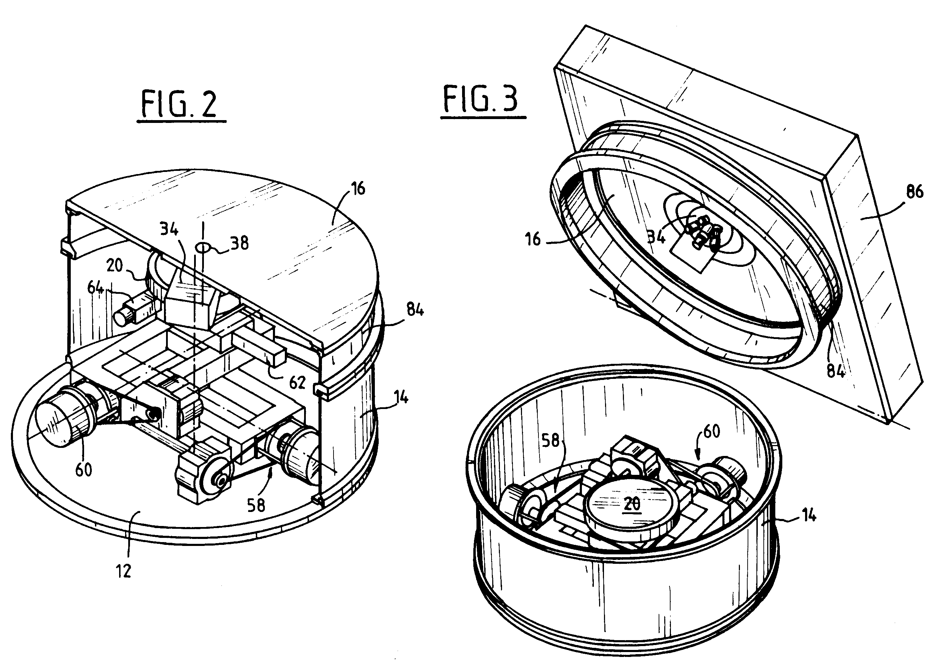

On se réfère maintenant aux figures 2 ou 3 où l'on a représenté les parties essentielles du mode de réalisation préféré d'une machine selon l'invention.

On reconnaît dans ces figures le couvercle 16 de l'enceinte 10, qui est solidarisé d'une jupe cylindrique 84 venant coiffer la paroi latérale cylindrique 14 de l'enceinte 10. Une tourelle porte-objectifs 34 est fixée sous le couvercle 16, en regard du hublot 38. La tourelle porte-objectifs est de préférence motorisée, et équipée d'objectifs ayant la même longueur, de sorte que l'on peut changer rapidement d'objectif sans modification du reste de la machine. Le réacteur 20 est de forme cylindrique. Les moyens de déplacement 58, 60, 62, 64 sont du type à micro-moteurs électriques.

La jonction entre la paroi cylindrique 14 de l'enceinte et la jupe 84 du couvercle 16 se trouve sensiblement au niveau du couvercle du réacteur 20, ce qui permet un accès facile à l'objet placé dans ce réacteur. La paroi cylindrique 14 est elle-même amovible, pour faciliter la maintenance de la machine. Les joints d'étanchéité prévus entre les diverses parties de la machine sont par exemple des joints toriques commercialisés sous la dénomination "VITON", réalisés en une matière qui est à peu près inerte chimiquement.

Comme on le voit en figure 3, le couvercle 16 peut être solidaire d'une platine 86 sur laquelle on peut prévoir une partie des systèmes optiques des voies de transmission du faisceau laser, d'éclairage et de visualisation.

L'invention s'applique essentiellement à des circuits électroniques, des circuits hybrides, des écrans plats de visualisation, des têtes de lecture magnétiques, etc...

## Revendications

1. Machine à microfaisceau laser d'intervention sur des objets à couche mince (32), en particulier pour la gravure ou le dépôt de matière par voie chimique en présence d'un gaz réactif, comprenant une enceinte étanche (10) dans laquelle est logé un réacteur étanche (20) recevant un objet à couche mince (32), des moyens (72, 80) pour abaisser la pression dans l'enceinte (10) et dans le réacteur (20), des moyens (74) pour introduire un gaz réactif à basse pression dans le réacteur, et une source laser (40) associée par des moyens optiques (42) de transmission du faisceau laser à un objectif de focalisation (34) orienté vers l'objet à couche mince, caractérisée en ce que l'objectif de focalisation est un objectif de microscope (34) disposé à l'intérieur de l'enceinte (10) et porté par une paroi (16) de celle-ci, et en ce que le réacteur (20) est fermé de façon étanche par un couvercle transparent (22) de faible épaisseur traversé par le faisceau laser issu de l'objectif de microscope.

2. Machine selon la revendication 1, caractérisée en ce que ledit couvercle transparent (22) du réacteur (20) est constitué par l'objet à couche mince (32), dont la couche mince est orientée vers l'intérieur du réacteur pour être en contact avec le gaz réactif, lorsque ledit objet à couche mince est constitué d'une plaque transparente portant la couche mince précitée.

3. Machine selon la revendication 1 ou 2, caractérisée en ce qu'elle comprend des moyens (82) de régulation de la pression dans l'enceinte (10) à une valeur sensiblement égale ou légèrement supérieure à celle de la pression de gaz réactif dans le réacteur (20), par introduction d'un gaz inerte tel que de l'azote dans l'enceinte (10).

4. Machine selon la revendication 1, 2 ou 3, caractérisée en ce que la paroi (16) de l'enceinte, à laquelle est fixé l'objectif de microscope (34), comporte un hublot (38) transparent au rayonnement laser pour la transmission de ce rayonnement à l'objectif du microscope (34), ayant une épaisseur lui permettant de résister à des variations de pression d'au moins une atmosphère.

5. Machine selon l'une des revendications 1 à 4, caractérisée en ce que le réacteur (20) est porté par des moyens moteurs (58, 60, 62, 64) de déplacement par rapport à trois axes perpendiculaires, et ces moyens moteurs sont également logés dans ladite enceinte (10).

6. Machine selon l'une des revendications précédentes, caractérisée en ce que le réacteur (20) comprend une table (24) de support de l'objet à couche mince (32), des moyens sollicitant cette table vers le couvercle transparent (22), et des moyens (30) formant cale d'épaisseur, pour le réglage de la distance entre la table (24) et le couvercle transparent (22) et le maintien de l'objet (32) en position sur la table (24).

7. Machine selon l'une des revendications précédentes, caractérisée en ce que le fond (12) de l'enceinte comprend des passages traversants dans lesquels sont montés à étanchéité des conduits (68, 70, 76, 78) reliés aux moyens d'abaissement (72, 80) et de régulation (82) de la pression et à une source (74) de gaz réactif, et des câbles ou fils d'alimentation et de commande des moyens (58, 60, 62, 64) de déplacement du réacteur.

8. Machine selon l'une des revendications précédentes, caractérisée en ce que l'enceinte (10) comprend une paroi amovible (16), permettant l'accès au réacteur (20).

9. Machine selon la revendication 8, caractérisée en ce que la paroi amovible de l'enceinte est son couvercle (16), monté par exemple à pivotement autour d'un axe transversal et associé à des vérins de manoeuvre (18).

10. Machine selon la revendication 8 ou 9, caractérisée en ce que l'objectif de microscope (34), ou une tourelle porte-objectifs, est fixé sur la paroi amovible (16) de l'enceinte.

11. Machine selon l'une des revendications précédentes, caractérisée en ce qu'elle comprend, outre une voie de transmission du faisceau laser (36), une voie d'éclairage (44, 46) et une voie de visualisation (48, 50, 52) aboutissant toutes à l'objectif de microscope (34), la voie de visualisation comprenant des filtres optiques (50), une caméra vidéo (48) et un écran vidéo (52) permettant l'observation en continu de l'action du microfaisceau laser (54) sur l'objet à couche mince (32).

## Claims

1. A laser microbeam machine for acting on thin film objects (32), in particular for chemically etching or depositing material in the presence of a reactive gas, the machine comprising a sealed enclosure (10) in which a sealed reaction chamber (20) receiving thin film objects (32) is lodged; means (72, 80) for reducing the pressure in the enclosure (10) and in the reaction chamber (20); means (74) for introducing reactive gas into the reaction chamber at low pressure; and a laser source (40) linked by optical means (42) for transmitting the laser beam to a lens (34) pointing towards the thin film object to be treated, the machine being characterized in that the objective lens is a microscope lens (34) disposed inside the enclosure (10) and carried by one of the walls (16) of the enclosure, and in that the reaction chamber (20) is sealed by a thin transparent lid (22) through which the laser beam from the microscope lens passes.

2. A machine according to claim 1, characterized in that, when said thin film object is constituted by a transparent plate carrying the above-mentioned thin film, said transparent lid (22) of the reaction chamber (20) is constituted by the thin film object (32), with the thin film pointing towards the inside of the reaction chamber in order to come into contact with the reactive gas.

3. A machine according to claim 1 or 2, characterized in that it includes means (82) for regulating the pressure inside the enclosure to a value which is substantially equal to or slightly greater than the pressure of the reactive gas inside the reaction chamber (20), said means operating by inserting an inert gas such as nitrogen into the enclosure (10).

4. A machine according to claim 1, 2, or 3, characterized in that the wall (16) of the enclosure on which the microscope lens (34) is fixed includes a window (38) which is transparent to the laser radiation in order to transmit said radiation to the microscope lens (34), the window being of sufficient thickness to withstand pressure variations of at least one atmosphere.

5. A machine according to any one of claims 1 to 4, characterized in that the reaction chamber (20) is carried by drive means (58, 60, 62, 64) for displacing it relative to three perpendicular axes, with said drive means being likewise housed inside said enclosure (10).

6. A machine according to any preceding claim, characterized in that the reaction chamber (20) includes a table (24) for supporting the thin film objects (32), with means urging said table towards the transparent lid (22), and means constituting a thickness wedge for adjusting the thickness between the table (24) and the transparent lid (22) and for holding the object (32) in position on the table (24).

7. A machine according to any preceding claim, characterized in that the bottom (12) of the enclosure includes through passages receiving in sealed manner ducts (68, 70, 76, 78) connected to suction means (72, 80), pressure-regulating means (82), and a source (74) of reactive gas, and also receiving in sealed manner cables or wires for feeding and controlling means (58, 60, 62, 64) for displacing the reaction chamber.

8. A machine according to any preceding claim, characterized in that the enclosure (10) includes a removeable wall (16) giving access to the reaction chamber (20).

9. A machine according to claim 8, characterized in that the removeable wall of the enclosure is constituted by its lid (16) which is mounted, for example, to pivot about a transverse axis and which is associated with operating actuators (18).

10. A machine according to claim 8 or 9, characterized in that the microscope lens (34) or a lens-carrying turret is fixed to the removeable wall (16) of the enclosure.

11. A machine according to any preceding claim, characterized in that in addition to a path (36) for transmitting the laser beam, it includes an illumination path (44, 46) and an observation path (48, 50, 52) both terminating at the microscope lens (34), with the observation path including optical filters (50), a video camera (48), and a video screen (52) enabling the action of the laser microbeam (54) on the thin film object (32) to be observed continuously.

## Patentansprüche

1. Lasermikrostrahlmaschine zur Einwirkung an Dünnschichtobjekten (32), insbesondere um auf chemischem Weg Material unter Anwesenheit eines reaktiven Gases wegzuätzen oder anzulagern, die aufweist: ein gedichtetes Gehäuse (10), in welchem sich ein dichter Reaktor (20) zur Aufnahme eines Dünnschichtobjektes (32) befindet, Mittel (72, 80) zum Verringern des Druckes in dem Gehäuse (10) und dem Reaktor (20), Mittel (74) zum Einbringen eines unter niedrigem Druck stehenden, reaktiven Gases in den Reaktor und eine Laserstrahlquelle (40), die über optische Mittel (42) zur Transmission des Laserstrahls mit einer Fokussiervorrichtung (34) gekoppelt ist, welche in Richtung des Dünnschichtobjektes ausgerichtet ist, **dadurch gekennzeichnet**, **daß** die Fokussiervorrichtung ein Mikroskopobjektiv (34) ist, das im Inneren des Gehäuses (10) angeordnet ist und von einer Wand (16) desselben gehalten wird, und daß der Reaktor (20) mittels einer dünnen transparenten Abdeckung (22) dicht abgeschlossen ist, welche von dem aus dem Mikroskopobjektiv emittierten Laserstrahl durchstrahlt wird.

2. Maschine nach Anspruch 1, **dadurch gekennzeichnet**, **daß** die transparente Abdeckung (22) des Reaktors (20) aus dem Dünnschichtobjekt (32) gebildet wird, dessen dünne Schicht gegen das Innere des Reaktors gerichtet ist, um mit dem reaktiven Gas in Kontakt zu geraten, wenn das Dünnschichtobjekt aus einer transparenten Platte besteht, welche die genannte dünne Schicht trägt.

3. Maschine nach Anspruch 1 oder 2, **dadurch gekennzeichnet**, **daß** sie Mittel (82) zur Regelung des Druckes in dem Gehäuse (10) aufweist, welche den Druck in diesem Gehäuse (10) durch Einbringen eines Inertgases, wie Stickstoff, auf einen Wert regeln, der gleich oder etwas höher als jener des reaktiven Gases in dem Reaktor (20) ist.

4. Maschine nach Anspruch 1, 2 oder 3, **dadurch gekennzeichnet**, **daß** die Wand (16) des Gehäuses, an welcher das Mikroskopobjektiv (34) angebracht ist, ein für Laserstrahlen transparentes Fenster (38) zur Transmission dieser Strahlen in das Mikroskopobjektiv (34) aufweist, wobei dieses Fenster eine solche Dicke besitzt, daß es Druckschwankungen von zumindest einer Atmosphäre widersteht.

5. Maschine nach einem der Ansprüche 1 bis 4, **dadurch gekennzeichnet**, **daß** der Reaktor (20) von Motormitteln (58, 60, 62, 64) zur Bewegung in bezug auf drei normal aufeinander stehende Achsen gehalten wird, wobei diese Motormittel ebenso in dem Gehäuse (10) untergebracht sind.

6. Maschine nach einem der vorigen Ansprüche, **dadurch gekennzeichnet**, **daß** der Reaktor (20) einen Tisch (24) zum Halten des Dünnschichtobjektes (32), Mittel, die diesen Tisch in Richtung der transparenten Abdeckung (22) belasten, und Mittel (30) aufweist, die eine Unterlegplatte zur Steuerung des Abstandes zwischen dem Tisch (24) und der transparenten Abdeckung (22) und zum Halten des Objektes (32) an seiner Position auf dem Tisch (24) bilden.

7. Maschine nach einem der vorigen Ansprüche, **dadurch gekennzeichnet**, **daß** der Boden (12) des Gehäuses Durchführungen aufweist, an welchen gedichtete Leitungen (68, 70, 76, 78), die mit Evakuier- (72, 80) und Drucksteuermittein (82) und mit einer Quelle (74) eines reaktiven Gases verbunden sind, und Versorgungs- und Steuerleitungen für die Mittel (58, 60, 62, 64) zum Verschieben des Reaktors dichtend angeschlossen sind.

8. Maschine nach einem der vorigen Ansprüche, **dadurch gekennzeichnet**, **daß** das Gehäuse (10) eine abnehmbare Wand (16) aufweist, welche den Zugang zu dem Reaktor ermöglicht.

9. Maschine nach Anspruch 8, **dadurch gekennzeichnet**, **daß** die abnehmbare Wand des Gehäuses (10) dessen Abdeckung (16) ist, die beispielsweise um eine Querachse verschwenkbar ist und mit Stellzylindern (18) zusammenwirkt.

10. Maschine nach Anspruch 8 oder 9, **dadurch gekennzeichnet**, daß das Mikroskopobjektiv (34) oder ein Objektiv-Revolverkopf an der abnehmbaren Wand (16) des Gehäuses befestigt ist.

11. Maschine nach einem der vorigen Ansprüche, **dadurch gekennzeichnet**, **daß** sie zusätzlich zu demTransmissionspfad des Laserstrahls (36) einen Beleuchtungspfad (44, 46) und einen Betrachtungspfad (48, 50, 52) aufweist, die alle in das Mikroskopobjektiv (34) münden, wobei der Betrachtungspfad optische Filter (50), eine Video-Kamera (48) und einen Video-Bildschirm (52) aufweist, welche ein kontinuierliches Beobachten der Wirkung des Lasermikrostrahles (54) an dem Dünnschichtobjekt (32) ermöglichen.
